# EUROPÄISCHE PATENTSCHRIFT

(11) **EP 1 902 478 B1**
(45) Veröffentlichungstag und Bekanntmachung des Hinweises auf die Patenterteilung: **18.08.2010**
(21) Anmeldenummer: 06743133.8
(22) Anmeldetag: 08.06.2006
(51) Int. Cl.: H01L 33/44, H01L 33/56, H01L 31/0203, H01L 31/0216

(54) **OPTOELEKTRONISCHE BAUELEMENTE MIT HAFTVERMITTLER**
OPTOELECTRONIC COMPONENTS COMPRISING ADHESIVE
COMPOSANTS OPTOELECTRONIQUES A PROMOTEUR D'ADHERENCE

(30) Priorität: 08.07.2005 DE 102005032078; 16.08.2005 DE 102005038698
(43) Veröffentlichungstag der Anmeldung: 26.03.2008
(73) Patentinhaber: Ledon Lighting Jennersdorf GmbH, 8380 Jennersdorf (AT); Lumitech Produktion und Entwicklung GmbH, 8380 Jennesdorf (AT)
(72) Erfinder: SCHRANK, Franz, A-8074 Raab (AT); PACHLER, Peter, A-8042 Graz (AT)
(74) Vertreter: Rupp, Christian
(86) Internationale Anmeldenummer: PCT/EP2006/005506
(87) Internationale Veröffentlichungsnummer: WO 2007/006378

(56) Entgegenhaltungen:
- EP-A- 1 249 874
- EP-A- 1 267 423
- EP-A- 1 475 846
- WO-A-2004/082036
- WO-A-2004/109813
- DE-A1- 19 905 697
- US-A- 5 187 547
- US-A1- 2002 070 449
- US-A1- 2005 253 213
- PATENT ABSTRACTS OF JAPAN Bd. 2003, Nr. 12, 5. Dezember 2003 (2003-12-05) & JP 2003 249691 A (MATSUSHITA ELECTRIC), 5. September 2003 (2003-09-05)
- PATENT ABSTRACTS OF JAPAN Bd. 1999, Nr. 13, 30. November 1999 (1999-11-30) & JP 11 222555 A (GE TOSHIBA SILICONE KK), 17. August 1999 (1999-08-17)
- PATENT ABSTRACTS OF JAPAN Bd. 2002, Nr. 11, 6. November 2002 (2002-11-06) & JP 2002 198570 A (TOYODA GOSEI), 12. Juli 2002 (2002-07-12)

## Beschreibung

LED-Module (LED = Leuchtdiode) in COB-Technik (COB = chip on board) werden meist mit Abdeckharzen auf Basis von Epoxidharzen versiegelt. Solche Module sind bspw. aus der EP 1347517 und der EP 1352431 bekannt. Wenngleich der Einsatz von Silikonen in den Patentansprüchen angeführt wird (z.B. auch in EP 1347517), werden solche Module in der Praxis noch nicht verwendet. Der Hauptgrund dafür ist die bekannte unzureichende Haftkraft dieser SilikonMaterialien.

Es sind auch Module mit aufgeklebten Linsen bekannt, auch hier werden als Kleber bevorzugt Systeme auf Basis von Epoxiden verwendet. Diese Materialien entwickeln üblicherweise eine sehr gute Haftkraft. Ein wesentlicher Nachteile der Epoxide ist aber ihre eingeschränkte Beständigkeit im Einsatz von blauen LEDs. Das emittierte Licht einer Wellenlänge von ca. 460 nm führt zu einer raschen Vergilbung dieser Harze, was wiederum zu einer Abnahme der Helligkeit der LED-Module führt. Bei Betrieb in feuchter Umgebung ist durch das Epoxid nur ein unzureichender Feuchteschutz für das Bauteil gegeben, die Beständigkeit bei Temperaturwechselbelastung ist nicht zufriedenstellend.

Neben oben beschriebenen Ausführungsformen sind noch zahlreiche weitere Konstruktionen von LED-Modulen und Leuchten bekannt. In einigen dieser Ausführungsformen werden wiederum Silikone als Verguss- oder Füllmaterialien genannt. Exemplarisch wird hier auf die Patente US 6504301, US 6590235, US 6204523 und DE 10261908 verwiesen. In keiner dieser Schriften wird jedoch auf die Haftung der Silikone auf den eingesetzten Materialien eingegangen. In einigen der beschriebenen Konstruktionen wird die mechanische Stabilität des Aufbaues durch zusätzliche konstruktive Maßnahmen gewährleistet (z.B. in US 6504301).

In anderen Ausführungsformen werden hingegen Silikongele eingesetzt, die aber bedingt durch ihre Beschaffenheit keinerlei mechanischen Schutz für den Halbleiter und deren Bonddrähte gewährleisten können. Daher kann ein Gel immer nur in Verbindung mit anderen konstruktiven Maßnahmen eingesetzt werden.

Bei Einsatz von Epoxiden als Vergussharz für Photodioden, z.B. als Lichtsensor in Klimaanlagensteuerungen, ist ebenfalls die unzureichende Lichtechtheit der Harze ein limitierender Faktor für die Lebensdauer.

EP 1249874 offenbart ein optoelektronisches Bauelement, das einen LED-Die aufweist, der auf einem Träger montiert ist, wobei eine Si02-Schicht die Oberfläche des LED-Die abdeckt, und wobei auf die Si02-Schicht eine Abdeckung aus Silikonmaterial aufgebracht ist.

US 2002/070449 offenbart ein optoelektronisches Bauelement, das einen LED-Die aufweist, der auf einem Träger montiert ist, wobei eine Si02-Schicht die Oberfläche des LED-Die und einem Teilbereich der Oberfläche des Trägers abdeckt, und wobei auf die Si02-Schicht eine Abdeckung aufgebracht ist.

Es ist daher Aufgabe der vorliegenden Erfindung, eine verbesserte Montageverbindung im Bereich optischer Bauelemente, insbesondere LEDs vorzuschlagen.

Diese Aufgabe wird erfindungsgemäss durch die Merkmale der unabhängigen Ansprüche 1, 14, 15 gelöst. Die abhängigen Ansprüche 2 bis 13 bilden den Gedanken der Erfindung besonders vorteilhaft weiter.

Zusammengefasst ist also der Hintergrund der Erfindung wie folgt zu verstehen: Es sind verschiedene Verfahren zur Abscheidung dünner SiO₂-Schichte bekannt. Die Plasmaabscheidung solcher Schichten wird beispielsweise in DE 198 07 086 beschrieben. Ebenso bekannt ist die Technik, aufgeflammte SiO₂-Schichten zur Haftvermittlung

einzusetzen. Eine derartige Ausführung ist z.B. in DE 199 05 697 A1 beschrieben.

Gemäss der Erfindung werden derartige Haftschichten erstmals bei optoelektronischen Komponenten eingesetzt werden. Es können damit dauerhafte Verklebungen mit Silikonkautschuken hergestellt werden. Diese Materialien haben üblicherweise nur eine unzureichende Haftfestigkeit auf Materialien, wie sie häufig für optoelektronische Komponenten, wie z.B. LED-Modulen, eingesetzt werden. Dies führt dann in weiterer Folge zu einer deutlichen Verminderung der Lebensdauer der gefertigten Komponenten. Durch den Einsatz der Haftschichten werden diese Einschränkungen wirkungsvoll vermieden, die Beständigkeit bei Betrieb in feuchter Umgebung und bei Temperaturwechselbelastung wird wesentlich verbessert.

Die Erfindung bezieht sich also nicht auf SiO₂ in einem LED-Chip selbst, sondern ausserhalb des Chips, nämlich als Haftvermittler bei der Montage des Chips, wenn diese LED-Chips zu Leuchten weiterberarbeitet werden.

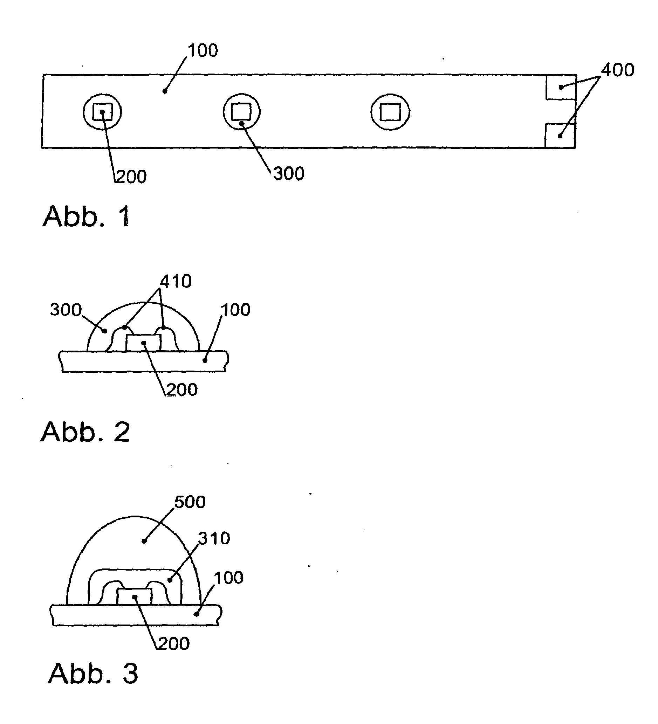

Die Erfindung soll nunmehr anhand von Ausführungsbeispielen und den begleitenden Figuren näher erläutert werden.
- Figur: 1 zeigt dabei ein Modul mit einem Abdeckharz,
- Figur: 2 ist ein Ausschnitt aus diesem Modul gemäss Figur 1 im Schnittbild,
- Figur: 3 ist ein entsprechender Ausschnitt eines Moduls mit aufgesetzten Linsen,
- Figur 4: ist eine Schnittansicht eines weiteren Moduls,
- Figur 5: zeigt ein erfindungsgemässes Modul, und
- Figuren 6a, 6b: zeigen Schnittansichten weiterer erfindungsgemässer Module

In Figur 1 ist in einer Aufsicht ein LED-Modul mit einem Abdeckharz dargestellt. In einer günstigen Ausführungsform ist die Abdeckung halbkugelförmig, zentrisch über dem LED-Die ausgebildet. Auf das Trägermaterial 100 (z.B. Leiterplatte auf Basis FR4) werden die LED-Die 200 geklebt oder verlötet. Das Abdeckharz 300 wird in flüssiger Form aufgebracht und anschließend gehärtet. Zur Kontaktierung werden meist lötbare Anschlusspads 400 eingesetzt.

In Figur 2 ist ein Ausschnitt aus diesem Modul gemäss Figur 1 im Schnittbild dargestellt. Das Trägermaterial 100, der Die 200 und das Abdeckharz 300 ist dabei wie in Figur 1 dargestellt. In dieser vergrößerten Abbildung sind die gebondeten Anschlussdrähte 410 dargestellt, mittels der der Die 200, der in COB-Technik (Chip-on-board) montiert ist, mit dem Träger (Leiterplatte) 100 elektrisch kontaktiert ist.

In Figur 3 ist ein entsprechender Ausschnitt eines Moduls mit einer aufgesetzten Linse 500 dargestellt. Die Verklebung erfolgt dabei mit einem Reaktionsharz 310, das den Raum zwischen der Linse 500 und dem Die ausfüllt. Entsprechend dem Stand der Technik kann in den Abdeckharzen zu einer Erzeugung von Weisslicht-Emission ein sogenannter phosphoreszierender Leuchtstoff enthalten sein (wie z.B. in EP 1347517 beschrieben), der bspw. einen Teil des von einer LED ausgestrahlten Lichts in einen anderen Wellenlängenbereich umsetzt, so dass die Mischung ein im wesentlichen weisses Licht ergibt. Bei aufgeklebten Linsen kann dieser Leuchtstoff zusätzlich oder alternativ im verwendeten Kleber eingesetzt werden.

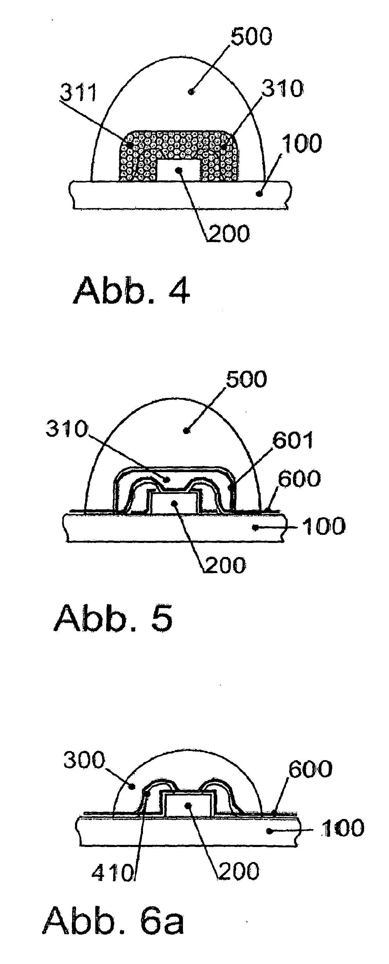

In Figur 4 ist ein derartiger Aufbau skizziert. In der Linse ist dabei vorzugsweise ein definierter Hohlraum vorgesehen, der mit dem Kleber 310 ausgefüllt wird. In diesem Kleber 310 dispergiert ist der Leuchtstoff 311.

Zur Verbesserung der Haftung der Silikone auf den verwendeten Materialien werden Si02-Haftschichten eingesetzt. Im Prinzip können alle bekannten Verfahren zur Schichtabscheidung eingesetzt werden.

Die Haftschichten weisen bevorzugt eine Dicke von wenigen nm (10⁻⁹ m) auf.

Durch entsprechende Prozessführung können diese Schichten auf Kunststoffe (Beschichtungen und Lötstopplacke der Träger), auf Metalle (elektrische Anschlüsse, Träger bzw. Teile des Trägers), auf die LED-Die und auch auf die eingesetzten Linsen (Kunststoffe wie z.B. Polyacrylat, PMMA oder COC, sowie Gläser) abgeschieden werden. Der Prozess der Beschichtung kann so ausgeführt werden, dass auf allen vorgenannten Materialien eine gute und langzeitstabile Haftung der abgeschiedenen SiO₂-Schicht erzielt wird. Entscheidend ist allerdings, dass auf den Haftschichten aufgebrachte Silikonmaterialien nach erfolgter Vernetzung sehr gute Haftfestigkeitswerte aufweisen.

Im folgenden werden beispielhaft Messwerte von erfindungsgemässen Ausführungsformen angeführt. In Figur 5 ist eine Zeichnung eines derartigen Moduls dargestellt. Auf den Träger 100 wird ein LED-Die 200 aufgebracht. Nach der elektrischen Kontaktierung mit den Anschlussdrähten 410 wird auf die gesamte Oberfläche die (stark vergrößert eingezeichnete) Haftschicht 600 abgeschieden. Diese Haftschicht ist eine SiO₂-Schicht. Die Kontrollmessung der Helligkeit der LED-Die 200 zeigt, dass weder die thermische Belastung durch das Abscheideverfahren noch die Schicht selbst zu einer Reduktion des emittierten Lichtes führen. In zahlreichen Messreihen wurde keine Änderung des Mittelwertes nach der Schichtabscheidung gefunden.

Auf den Die 200 wird dann ein Reaktionsharz 310 auf Silikonbasis aufgebracht, derart dass die Haftvermittlerschicht zwischen dem Silikonmaterial und dem Die 200 bzw. dem Träger 100 liegt.

Über dem LED-Die 200 wird dann eine Linse 500 aufgeklebt. Vor der Verklebung mit dem Reaktionsharz 310 (auf Silikonbasis) wird auf der dem Dice 200 zugewandten Unterseite der Linse 500 eine Haftschicht 601 aus SiO₂ abgeschieden (wiederum stark vergrößert dargestellt).

Somit kann eine Haftvermittlerschicht zwischen der Abdeckung (Linse) 500 und dem Reaktionsharz und/oder dem Reaktionsharz und dem Die 200 und dem Träger vorgesehen sein. Bevorzugt, aber nicht obligatorisch, liegt die Haftvermittlerschicht auf der gesamten Kontaktfläche vor.

Die geometrische Form und das Material des Trägers 100 sind nicht auf die vorhin beschriebene Ausführungsform beschränkt. Der Träger kann eine Leiterplatte aus FR4, Metall oder Keramik sein.

Ebenso kann der Träger aus einem Kunststoffmaterial (Thermoplast oder Duroplast) bestehen. Ein entsprechend mit Kunststoff umspritzter sog. Leadframe kann ebenso eingesetzt werden.

Zur Beurteilung der Haftfestigkeit wurden die Abscherkräfte bestimmt. In Vergleichsmessungen wurden die Haftfestigkeiten auch nach einem Temperaturwechseltest bestimmt. Beispielhaft werden hier die Ergebnisse eines solchen Tests mit auf FR4 verklebten Glaslinsen genannt. Die angegebenen Zahlenwerte geben jene (mittlere) Belastung in [g] an, die zu einer Ablösung der aufgebrachten Linse führt.

| | |
|---|---|
| a.) Ohne Haftschichten: | 1200 |
| nach TW: | 1000 |
| | |
| b.) Haftschicht auf FR4: | 5600 |
| nach TW | 4900 |
| | |
| c.) Haftschicht auf FR4 und Glas: | 9700 |
| nach TW | 9700 |

| | |
|---|---|
| (TW = Temperaturwechseltest) | |

Es wurden auch ähnliche Versuchsaufbauten mit Kunststofflinsen hergestellt. Es zeigt sich, dass das Material der Linse keinen Einfluss auf die Haftfestigkeit hat, entscheidend sind die Qualität und die Haftung der abgeschiedenen SiO2-Schicht. Die Qualität der Haftschicht lässt sich leicht in der visuellen Analyse der Prüflinge nach dem Abschertest feststellen. Bei "guten" Haftschichten reißt der Silikonkautschuk, die Klebefuge geht dabei nicht auf.

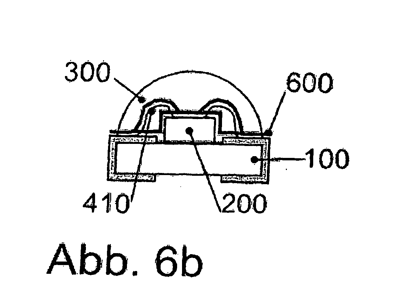

Ähnlich gute Ergebnisse werden in der Prüfung von Modulen entsprechend Figur 6 erzielt (6a zeigt eine COB-Version, 6b eine SMT-Version). Die Haftschicht 600 wird bevorzugt wie in obigem Beispiel auf die gesamte Oberfläche, d.h. dem Träger 100, dem LED-Die 200 und ggf. die Anschlussdrähte 410 abgeschieden. Es wird also die gesamte Oberseite des optoelektronischen Bauteils einschliesslich der Seitenflächen mit einer Haftschicht überzogen.

(Alternativ kann die Haftschicht 600 nur auf einem von Träger 100 und Die 200 bzw. auf Teilbereichen davon vorliegen, wobei die Teilbereiche Träger und Die überlappen können.)

Mittels Dispenstechnik wird dann das flüssige Silikon in Form einer Halbkugel 300 aufgebracht. Nach der Vernetzung des Silikonkautschukes werden zur Beurteilung der Haftung des Abdeckmaterials ein Feuchtetest und ein Temperaturschocktest zur indirekten Prüfung eingesetzt. In einem direkten Vergleich im Feuchtetest 85°C und 85% relative Feuchte ergibt ein aktuell verwendetes Epoxid nach 600h einen Abfall der Helligkeit auf 50 bis 70% des Anfangswertes, ein zweites auch in der Produktion eingesetztes Epoxid weist nach dieser Testdauer lediglich noch 20% der Anfangshelligkeit auf, wobei auch einige Totalausfälle auftreten. Dagegen weisen entsprechende Module in der erfindungsgemäßen Ausführung nach 600h Testdauer noch mehr als 90% der Anfangshelligkeit auf.

Im Temperaturschocktest -40°C / 105°C ist bei Abdeckungen aus Silikonkautschuk nach 3000 Zyklen kein Ausfall zu beobachten. Wenngleich hier kein direkter Vergleich vorliegt, ist dennoch anzumerken, dass bei älteren Temperaturwechseltests mit Abdeckungen aus Epoxiden erste Ausfälle immer nach längstens 500 Zyklen aufgetreten sind. Diese Ergebnisse belegen in eindrucksvoller Weise, dass mit Hilfe dieser Haftschichten Silikonkautschuke ohne jegliche weitere konstruktive Maßnahmen eine feste Verbindung zu den eingesetzten Materialien ausbilden. Die Haftfestigkeit wird weder durch höhere Temperatur noch durch Feuchte herabgemindert. Die Verklebungen weisen zudem auch keine Empfindlichkeit gegenüber Temperaturwechselbelastung auf. Wichtig ist, dass die Silikone keinerlei Haftvermittler oder ähnliche Additive enthalten müssen. Somit können alle optisch transparenten Materialien eingesetzt werden. Derartige Kautschuke werden von mehreren Herstellern angeboten.

Einige dieser kommerziell erhältlichen Silikone erfüllen auch die Anforderungen hinsichtlich der Beständigkeit gegenüber UV-Bestrahlung. Die beständigsten Materialien zeigen nach 5000h im Dauerbetrieb mit blauen LEDs (ca. 460 nm dominante Wellenlänge) keinerlei Vergilbung. Nach den Ergebnisse der Bestrahlungstests (UVC Strahlung, 30 mW/cm2), wo auch nach einigen hundert Stunden keine Abnahme der Transparenz feststellbar ist, sollte auch nach 20000 Stunden und darüber im Dauerbetrieb keine Vergilbung des Silikons über der blauen LED auftreten.

## Patentansprüche

1. Optoelektronisches Bauelement,
das ein optoelektronische Bauteil (200) aufweist,
das auf einem Träger (100) montiert ist,
wobei eine optisch transparente Haftschicht (600, 601)
aus SiO₂ die Oberfläche des optoelektronischen Bauteils (200) abdeckt,
wobei auf die Haftschicht (600) eine Abdeckung (300) oder eine Klebeschicht (310) aus Silikonmaterial aufgebracht ist, **dadurch gekennzeichnet, dass** die optisch transparente Haftschicht (600) wenigstens einen Teilbereich der Oberfläche des Trägers (100) abdeckt.

2. Optoelektronisches Bauelement nach Anspruch 1,
wobei das optoelektronische Bauteil (200) ein Leuchtdioden-Chip ist.

3. Optoelektronisches Bauelement nach Anspruch 1 oder 2, wobei der Träger (100) eine Leiterplatte ist.

4. Optoelektronisches Bauelement nach Anspruch 3,
wobei das optoelektronische Bauteil (200) in Chip-on-Board-Technik auf die Leiterplatte (100) montiert ist.

5. Optoelektronisches Bauelement nach einem der vorhergehenden Ansprüche,
wobei die Haftschicht (600) eine Dicke von 100nm oder weniger, vorzugsweise 20nm oder weniger hat.

6. Optoelektronisches Bauelement nach Anspruch 1,
**dadurch gekennzeichnet,**
**dass** über das optoektronische, Bauteil (200) eine Linse (500) mittels der Klebeschicht (310) verklebt ist.

7. Optoelektronisches Bauelement nach Anspruch 2, wobei die Wellenlänge des emittierten Lichtes des Leuchtdioden-Chips (200) zwischen einschließlich dem UV-Bereich und einschließlich dem IR-Bereich liegt.

8. Optoelektronisches Bauelement nach Anspruch 1,
**dadurch gekennzeichnet,**
**dass** dem Silikonmaterial ein Leuchtstoff (311) beigemengt ist.

9. Optoelektronisches Bauelement nach Anspruch 1,
**dadurch gekennzeichnet,**
**dass** dem Silikonmaterial ein oder mehrere Füllstoffe zugesetzt sind.

10. Optoelektronisches Bauelement nach Anspruch 9,
**dadurch gekennzeichnet,**
**dass** die Füllstoffe ausgewählt sind aus der Gruppe von Kieselsäuren, körnigem Al2O3 und/oder BaSO4.

11. Optoelektronisches Bauelement nach Anspruch 1,
**dadurch gekennzeichnet,**
**dass** das optoektronische Bauteil (200) eine Photodiode ist.

12. Optoelektronisches Bauelement nach Anspruch 1,
in Surface Mounted Technology oder Radialbauweise.

13. Optoelektronisches Bauelement nach einem der vorhergehenden Ansprüche,
bei dem die Haftschicht (600) eine Dicke von maximal 10nm aufweist.

14. Verwendung einer SiO2-Schicht (600) als Haftvermittler auf einem optoelektronischen Bauteil (200) und einem Träger (100), zur Montage einer Abdeckung (300) oder Verklebung (310) aus Silikomonoterial über dem Träger (100) und dem optoelektronischen Bauteil (200).

15. Verfahren zur Herstellung eines optoelektronischen Bauelements nach einem der Ansprüche 1 bis 13, aufweisend die folgenden Schritte:
- Montage eines optoelektronischen Bauteils (200) auf einem Träger (100),
- Aufbringen einer SiO2-Schicht (600) als Haftvermittler auf der Oberfläche des optoelektronischen Bauteils (200) und wenigstens einem Teilbereich der Oberfläche der Oberseite des Trägers (100), und
- Aufbringen einer Verklebung (310) oder Abdeckung (300) aus Silikonmaterial auf der SiO2-Schicht.

## Claims

1. Optoelectronic device,
which has an optoelectronic component (200),
which is mounted on a carrier (100),
wherein an optically transparent adhesion layer (600, 601) composed of SiO₂ covers the surface of the optoelectronic component (200),
wherein a covering (300) or an adhesive layer (310) composed of silicone material is applied to the adhesion layer (600),
**characterized in that**
the optically transparent adhesion layer (600) covers at least one partial region of the surface of the carrier (100).

2. Optoelectronic device according to Claim 1,
wherein the optoelectronic component (200) is a light-emitting diode chip.

3. Optoelectronic device according to Claim 1 or 2,
wherein the carrier (100) is a printed circuit board.

4. Optoelectronic device according to Claim 3,
wherein the optoelectronic component (200) is mounted onto the printed circuit board (100) using chip-on-board technology.

5. Optoelectronic device according to any of the preceding claims,
wherein the adhesion layer (600) has a thickness of 100 nm or less, preferably 20 nm or less.

6. Optoelectronic device according to Claim 1,
**characterized**
**in that** a lens (500) is adhesively bonded above the optoelectronic component (200) by means of the adhesive layer (310).

7. Optoelectronic device according to Claim 2,
wherein the wavelength of the emitted light from the light-emitting diode chip (200) lies between the UV range and the IR range inclusive.

8. Optoelectronic device according to Claim 1,
**characterized**
**in that** a phosphor (311) is admixed with the silicone material.

9. Optoelectronic device according to Claim 1,
**characterized**
**in that** one or more fillers are added to the silicone material.

10. Optoelectronic device according to Claim 9,
**characterized**
**in that** the fillers are selected from the group of silicas, granular Al2O3 and/or BaSO4.

11. Optoelectronic device according to Claim 1,
**characterized**
**in that** the optoelectronic component (200) is a photodiode.

12. Optoelectronic device according to Claim 1,
using surface mounted technology or of radial design.

13. Optoelectronic device according to any of the preceding claims,
in which the adhesion layer (600) has a thickness of at most 10 nm.

14. Use of an SiO2 layer (600) as an adhesion promoter on an optoelectronic component (200) and a carrier (100), for mounting a covering (300) or adhesive bond (310) composed of silicone material above the carrier (100) and the optoelectronic component (200).

15. Method for producing an optoelectronic device according to any of Claims 1 to 13,
having the following steps:
- mounting an optoelectronic component (200) on a carrier (100),
- applying an SiO2 layer (600) as an adhesion promoter on the surface of the optoelectronic component (200) and at least one partial region of the surface of the top side of the carrier (100), and
- applying an adhesive bond (310) or covering (300) composed of silicone material on the SiO2 layer.

## Revendications

1. Composé optoélectronique, qui présente un élément optoélectronique (200), qui est monté sur un support (100),
une couche adhérente transparente optiquement (600, 601) en SiO₂ couvrant la surface de l'élément optoélectronique (200),
une couverture (300) ou une couche adhésive (310) en matériau de silicone est appliquée sur la couche adhérente (600),
**caractérisé en ce que** la couche adhérente optiquement transparente (600) couvre au moins une partie de la surface du support (100).

2. Composé optoélectronique selon la revendication 1, l'élément optoélectronique (200) étant un élément semi-conducteur à diodes électroluminescentes.

3. Composé optoélectronique selon la revendication 1 ou 2, le support (100) étant une platine ou circuit imprimé.

4. Composé optoélectronique selon la revendication 3, l'élément optoélectronique (200) étant monté sur la platine (100) selon la technique de montage direct de puce.

5. Composé optoélectronique selon l'une des revendications précédentes, la couche adhérente (600) ayant une épaisseur de 100 nm ou moins, de préférence 20 nm ou moins.

6. Composé optoélectronique selon la revendication 1, **caractérisé en ce que** au-dessus de l'élément optoélectronique (200) une lentille (500) est collée au moyen de la couche adhésive (310).

7. Composé optoélectronique selon la revendication 2, la longueur d'onde de la lumière émise du élément semi-conducteur (200) à diodes électroluminescentes se trouvant entre y compris le domaine UV et y compris le domaine IR.

8. Composé optoélectronique selon la revendication 1, **caractérisé en ce qu'**une substance luminescente (311) est incorporée au matériau de silicone.

9. Composé optoélectronique selon la revendication 1, **caractérisé en ce qu'**un ou plusieurs matériaux de remplissage sont ajoutés du matériau de silicone.

10. Composé optoélectronique selon la revendication 9, **caractérisé en ce que** les matériaux de remplissage sont choisis parmi le groupe des silices, Al2O3 granuleux et/ou BaSO4.

11. Composé optoélectronique selon la revendication 1, **caractérisé en ce que** l'élément optoélectronique (200) est une photodiode.

12. Composé optoélectronique selon la revendication 1, selon la technique du composant monté en surface ou une méthode de construction radiale.

13. Composé optoélectronique selon l'une des revendications précédentes, la couche adhérente (600) présentant une épaisseur de maximum 10 nm.

14. Utilisation d'une couche SiO₂ (600) comme promoteur d'adhérence sur un élément optoélectronique (200) et un support (100), pour le montage d'une couverture (300) ou collage (310) en matériau de silicone au-dessus du support (100) et de l'élément optoélectronique (200).

15. Procédé de fabrication d'un composé optoélectronique selon l'une des revendications 1 à 13, présentant les étapes suivantes :
- montage d'un élément optoélectronique (200) sur un support (100),
- application d'une couche SiO₂ (600) comme promoteur d'adhérence sur la surface de l'élément optoélectronique (200) et au moins une partie de la surface de la face supérieure du support (100), et
- application d'un collage (310) ou couverture (300) en matériau de silicone sur la couche SiO₂.
